# EUROPEAN PATENT APPLICATION

(11) **EP 4 528 760 A1**
(43) Date of publication of application: **26.03.2025**
(21) Application number: 24193405.8
(22) Date of filing: 07.08.2024
(51) Int. Cl.: H01F 17/00, H01L 23/64, H01F 27/28, H01F 27/30

(54) **VOLTAGE CONVERTER WITH INDUCTOR OR TRANSFORMER BETWEEN STACKED DIE**

(30) Priority: 25.09.2023 US 202318474160
(71) Applicant: INTEL Corporation, Santa Clara, CA 95054 (US)
(72) Inventor: BUTZEN, Nicolas, Portland, 97229 (US); KRISHNAMURTHY, Harish K., Beaverton, 97006 (US); RADHAKRISHNAN, Kaladhar, Chandler, 85226 (US); AHMED, Khondker, Hillsboro, 97124 (US); DESAI, Nachiket, Portland, 97229 (US); KIM, Su Hwan, Portland, 97225 (US); RAVICHANDRAN, Krishnan, Saratoga, 95070 (US)
(74) Representative: HGF

(57) **Abstract**

Embodiments herein relate to a voltage regular (VR) formed from die stacked on a package base layer. The die can include a load die stacked on a VR die, with an intermediate layer between the two dies. The VR can include an inductor or transformer as a charge transfer component formed between the dies. For example, the inductor or transformer windings can wind around the intermediate layer and include portions of top metal layers of the VR and load die, where the load die is inverted in the stack. The intermediate layer can be magnetic or non-magnetic for an inductor, or magnetic for a transformer. The VR can optionally be divided among two dies. The VR die may have a gallium nitride substrate to handle a higher input voltage, while the load die comprises a silicon substrate.

## Description

### FIELD

The present application generally relates to the field of voltage converters.

### BACKGROUND

Computing devices often rely on voltage converters, also referred to as voltage regulators, to obtain power. For example, direct current (DC)-to-DC voltage converters can convert a power supply at one DC voltage to another, typically lower DC voltage. A voltage converter can convert the main supply voltage of a computing device, such as 12 V, down to lower voltages, such as 5 V, 3.3 V or 1.8 V. The lower voltages can be used by various components in the computing device, such as a Universal Serial Bus (USB) interface, memory such as dynamic random access memory (DRAM) and processing resources such as a central processing unit (CPU). However, it is challenging to supply power in an efficient and cost-effective manner.

### BRIEF DESCRIPTION OF THE DRAWINGS

The embodiments of the disclosure will be understood more fully from the detailed description given below and from the accompanying drawings of various embodiments of the disclosure, which, however, should not be taken to limit the disclosure to the specific embodiments, but are for explanation and understanding only.
FIG. 1 depicts a cross-sectional view of a stack 100 comprising a package base layer 110, a voltage regulator (VR) die 120 and a load die 130, where an inductor 140 or 141 of a VR is located on or inside the package base layer, in accordance with various embodiments.
FIG. 2 depicts a cross-sectional view of a stack 200 comprising a package base layer 210, a VR die 220 and a load die 230, where an inductor 240 of a VR is located between the die, in accordance with various embodiments.
FIG. 3 depicts a cross-sectional view of a stack 300 comprising a package base layer 310, a VR die 320, an intermediate layer 330 and a load die 340, where a transformer 350 of a VR is located between the die, in accordance with various embodiments.
FIG. 4A depicts a perspective view of a stack 400 comprising a package base layer 410, a VR die 420, an intermediate layer 430 and a load die 440, where an example spiral inductor 450 is formed in a portion of a top metal layer of the VR die, and an example coil 460 of an inductor or transformer is formed in portions of top metal layers of the VR die and the load die, with windings around a portion of the intermediate layer, in accordance with various embodiments.
FIG. 4B depicts a top down view of the package of FIG. 4A, showing a magnetic material 431 in the intermediate layer 430, where the inductor 460 comprises windings around the magnetic material, in accordance with various embodiments.
FIG. 5 depicts a cross-sectional view of a stack 500 comprising the VR die 420, the intermediate layer 430 and the load die 440 of FIG. 4A, including metal layers of the VR die 420 and the load die 440, where the load die is in an inverted position relative to the VR die, and the inductor 460 comprises portions of the top metal layers of the VR die and the load die, in accordance with various embodiments.
FIG. 6 depicts a cross-sectional view of a stack 600 comprising a package base layer 610, a VR die 620, a magnetic intermediate layer 630 and a load die 640, where a buck VR 650, a boost VR 660 and single-input, multiple-output (SIMO) VR 670 are formed with inductors 651, 661 and 671, respectively, located between the die, in accordance with various embodiments.
FIG. 7 depicts a cross-sectional view of a stack 700 comprising a package base layer 710, a VR die 720, a magnetic intermediate layer 730 and a load die 740, where a transformer 750 of a fly back VR 790 is located between the die, in accordance with various embodiments.
FIG. 8 depicts a cross-sectional view of a stack 800 comprising a package base layer 810, a first VR die 820 for converting a high voltage Vin to an intermediate voltage Vout1, a magnetic intermediate layer 830, a second VR die 840 and a load die 850, where the transformer 750 is located between the first and second VR die, and an additional VR 795 in the second VR die 840 is used to down convert Vout1 to a low voltage, Vout2, in accordance with various embodiments.
FIG. 9 depicts a circuit diagram of a 2:1 switched capacitor-based VR as an example implementation of the VR 795 of FIG. 8, in accordance with various embodiments.
FIG. 10 depicts a cross-sectional view of a stack 1000 comprising a package base layer 1010, a VR die 1020, an intermediate layer 1030 and a load die 1040, where an example forward VR 1050 is formed with a transformer 1060 located between the die, in accordance with various embodiments.
FIG. 11 illustrates an example of components that may be present in a computing system 1150 for implementing the techniques (e.g., operations, processes, methods, and methodologies) described herein.

### DETAILED DESCRIPTION

Inductor-based power converters, also referred to as voltage regulators (VRs), can provide very efficient power conversion from the transformer effect across a wide range of output voltages, compared to linear regulators. However, using a high quality factor (Q) inductor with small DC resistance is important, because otherwise inductor-related losses can dominate and compromise the efficiency of the VR. Moreover, the location of the inductor is important as it should be as close as possible to the power stage circuits and the receiving end to minimize direct current (DC) resistance losses through metal traces and vias in high-current power paths. Especially in vertically-stacked systems where multiple dies are stacked vertically, power paths can include through-silicon vias (TSVs) in addition to package vias to reach the top load die. These paths can significantly impact the efficiency and compromise signal routing.

One approach is to place the inductor on the board or on the package's die side. However, in this approach, the power paths to the inductor from both the VR die and the load die include a TSV through the VR die, lateral package routing and package vias, which could incur significant ohmic losses. Another approach is to integrate the inductor into the package base layer. This approach can eliminate the lateral package routing but still uses package vias and TSVs, which can compromise efficiency.

To overcome the above and other issues, an inductor or transformer of a VR can be placed between the VR die and load die in a stack to minimize routing resistance. The input terminal of the inductor or transformer can be connected to the VR die, while the output terminal of the inductor or transformer is connected to the load die. The inductor or transformer can be constructed using the GM layer (top metal layer) of each die. An intermediate layer, which can be with or without a magnetic core, can be placed between the VR die and load die.

In another option, a second VR die is stacked on a first VR die, and a load die is stacked on the second die. The first VR die down converts an input voltage to an intermediate voltage and the second VR die down converts the intermediate voltage to a final output voltage for use by the load die.

The stacked die can be provided on a package base layer, where the base layer and the die form a stack which is encapsulated into a package.

In one option, the VR die and load die both comprises silicon substrates.

In another option, the VR die comprises a substrate material such as Gallium Nitride (GaN) which is able to handle higher input voltages than the load die, while the load die comprises a silicon substrate, which operates with a lower voltage.

The VR can be of various types. For example, inductor-based VRs include buck, boost and single-input, multiple-output (SIMO), while transformer-based VRs include fly back and forward VRs.

These and other features will be further apparent in view of the following discussion.

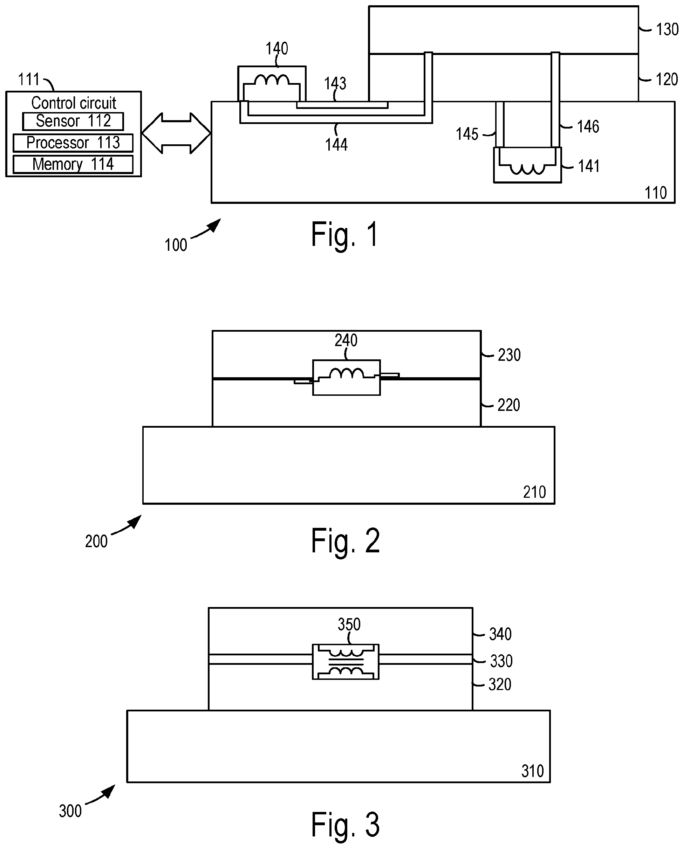

FIG. 1 depicts a cross-sectional view of a stack 100 comprising a package base layer 110, a voltage regulator (VR) die 120 and a load die 130, where an inductor 140 or 141 of a VR is located on or inside the package base layer, in accordance with various embodiments. The stack or stacked structure includes a base layer referred to as a package base layer 110 upon which a number of die are stacked, one atop the other. The package base layer can be mounted on a board such as a motherboard or other printed circuit board and include, on its underside, conductive points such as a ball grid array for communicating with circuits on the board. The package base layer can include conductive paths such as vias to couple the conductive points to a VR such as to input a voltage or ground the VR.

As mentioned, one option is to locate an inductor 140 on a top surface of the package base layer. The inductor 140 is part of a VR of the VR die, and includes conductive paths 143 and 144 which extend laterally and vertically. These conductive paths are coupled to other conductive paths and circuitry in the VR die such as switches. The conductive paths in the VR die can include paths in metal layers and TSVs, for example. These conductive paths can extend up to the load die. Another option is to locate an inductor 141 within the package base layer. In this case, conductive paths 145 and 146 are used to communicate with the VR die. As mentioned, the conductive paths on or in the package base layer result in significant resistance losses in such vertical power-delivery applications.

A control circuit 111 can communicate with the stack, and may include a sensor 112, a processor 113 and a memory 114. The memory stores instructions to be executed by the processor. The sensor is capable of sensing an output voltage of the VR and implementing a control loop to regulate the output voltage. The control circuit could be outside the package such as on the board to which the package is attached or in a low voltage domain such as in the load die. Providing the control circuit on the load die can be a good choice for integration, because the load die is low-voltage die and control circuits usually work with low voltages. Other options are possible as well.

FIG. 2 depicts a cross-sectional view of a stack 200 comprising a package base layer 210, a VR die 220 and a load die 230, where an inductor 240 of a VR is located between the die, in accordance with various embodiments. Locating the inductor between the die results in advantages such as reduced resistance losses. In particular, by placing the inductor between the two stacked dies, the power path resistance is significantly improved, as this approach reduces or eliminates the need to go through package vias, lateral package routing, or TSVs through the die and package base layer. This improves the end-to-end power conversion efficiency, extending the battery operation time and/or reducing cooling requirements. Also, this approach frees up more area for routing on the die stacks, which otherwise can be used for power TSVs, enabling more dense input/output or higher throughput die-to-die communication channels.

In some cases, an intermediate layer is provided between the first die 220 and the second die 230. An inductor of the VR can be wound around the intermediate layer, which can include a magnetic material to increase the magnetic field. Various VR designs can include one or more inductors.

FIG. 3 depicts a cross-sectional view of a stack 300 comprising a package base layer 310, a VR die 320, an intermediate layer 330 and a load die 340, where a transformer 350 of a VR is located between the die, in accordance with various embodiments. As in the case of an inductor, in some cases, an intermediate layer is provided between the die 320 and 340. A transformer of the VR can include primary and/or secondary windings around the intermediate layer, which can include a magnetic material to increase the magnetic field.

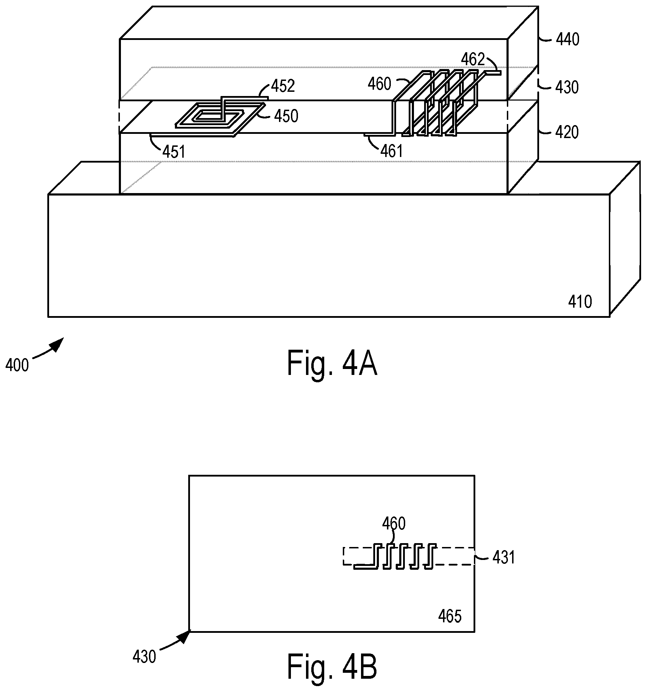

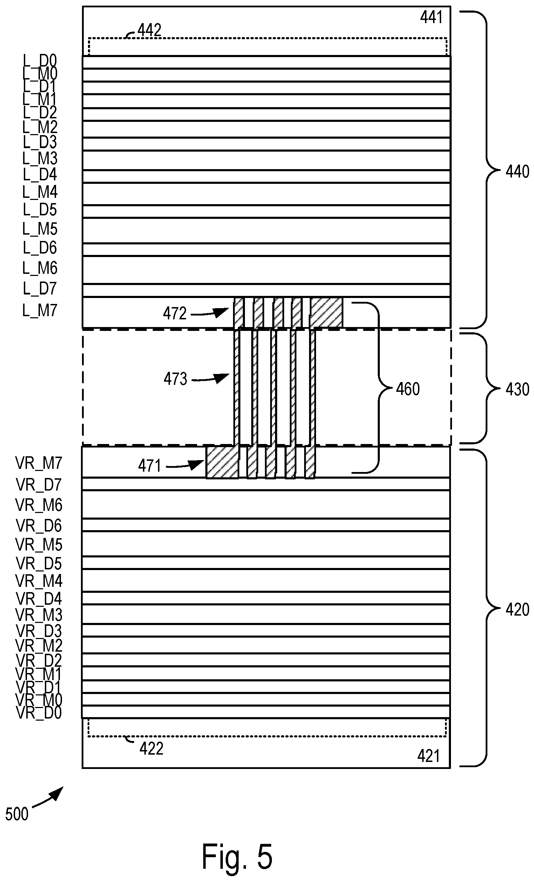

FIG. 4A depicts a perspective view of a stack 400 comprising a package base layer 410, a VR die 420, an intermediate layer 430 and a load die 440, where an example spiral inductor 450 is formed in a portion of a top metal layer of the VR die, and an example coil 460 of an inductor or transformer is formed in portions of top metal layers of the VR die and the load die, with windings around a portion of the intermediate layer, in accordance with various embodiments. The inductor 450 is planar and spiral shaped, and formed in a top metal layer of the VR die 420. An input end 451 of the inductor can be in the top metal layer of the VR die while an output end 452 of the inductor extends to a portion of the top metal layer of the load die. The load die is inverted in this example so that its top metal layer faces the top metal layer of the VR die. See also FIG. 5. In another option, the spiral inductor is provided in the top metal layer of the load die. In another option, both the VR die and load die include spiral shapes/conductive paths to create an inductance. The spiral shape creates a magnetic field which can be used to store and release energy as the VR converts the input voltage to a different output voltage.

In another option, the inductor 460 is a coil and includes windings (or vertical turns) around the intermediate layer 430, where the windings include portions of the top metal layers of the die 420 and 440. In particular, the laterally extending portions of the inductor can be in the portions of the top metal layers while the vertical extending portions can comprise TSVs or other vias which extend between the portions of the top metal layers of the two dies. The TSVs can comprises metal, in one approach. The inductor comprises a coil which is wound around a portion of the intermediate layer. An input end 461 of the inductor 460 can be in the top metal layer of the VR die while an output end 462 of the inductor is in the top metal layer of the load die.

The die 420 is a first die and the die 440 is a second die.

FIG. 4B depicts a top down view of the package of FIG. 4A, showing a magnetic material 431 in the intermediate layer 430, where the inductor 460 comprises windings around the magnetic material, in accordance with various embodiments. To increase the magnetic field when the inductor is a coil, the windings of the inductor are wound around a magnetic material in the intermediate layer. The magnetic material can be a metal-based material such as Fe (iron), Ni (nickel), Cu (copper), Mo (molybdenum), Mn (manganese), Cr (chromium), etc., or an iron oxide-based material, i.e., ferrite, such as MnFe2O3, CuFe2O3, ZnFe2O3, NiFe2O3, etc. Other example materials include amorphous cobalt alloys such as CoZrTa, CoFeHfO, CoAlO, FeSiO, CoFeAIO, CoNbTa, and CoZr.

The magnetic material can be elongated, e.g., rod-shaped, and formed in a surrounding dielectric material 465 of the intermediate layer, for example.

The intermediate layer could alternatively include a non-magnetic material as a so-called air core which is not necessary air but is a material with a very low degree of magnetism. The intermediate layer can be sandwiched between the VR die and the load die, in one possible implementation.

FIG. 5 depicts a cross-sectional view of a stack 500 comprising the VR die 420, the intermediate layer 430 and the load die 440 of FIG. 4A, including metal layers of the VR die 420 and the load die 440, where the load die is in an inverted position relative to the VR die, and the inductor 460 comprises portions of the top metal layers of the VR die and the load die, in accordance with various embodiments. By inverting the load die on top of the VR die, the top metal layers of the two die face one another and the distance between these layers is minimize to minimize resistive losses of conductive paths between these layers.

In the VR die, a substrate 421, e.g., silicon or GaN, comprises a transistor layer 422, e.g., a top portion of the substrate in which transistors are fabricated to create circuits. Above the substrate are alternating dielectric and metal layers. For example, dielectric layers VR_D0-VR_D7 and metal layers VR_M0-VR_M7 are depicted, where VR_M7 is the topmost metal layer (a first top metal layer). The metal layers can comprise aluminum or copper, and the dielectric layers can comprise oxide, for example.

In the load die, a substrate 441, e.g., silicon, comprises a transistor layer 442. Above the substrate are alternating dielectric and metal layers such as dielectric layers L_D0-L_D7 and metal layers L_M0-L_M7, where L_M7 is the topmost metal layer (a second top metal layer). The metal layers become thicker further from the substrate. When the load die is inverted, the alternating dielectric and metal layers are below the substrate. Eight metal layers are depicted as an example only.

As in FIG. 4A and 4B, the inductor 460 comprises a coil with windings around the intermediate layer 430. The inductor is shown in a cross-sectional view and includes portions 471 of VR_M7 and portions 472 of L_M7, in addition to vertically extending portions 473 such as vias which extend through the intermediate layer.

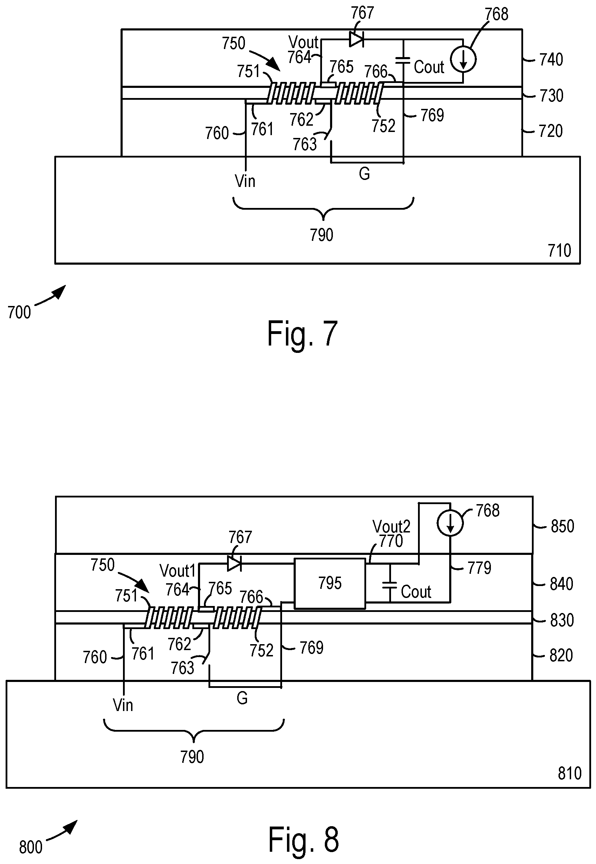

In some implementations, such as in FIG. 8, a second VR die is on a first VR die. In this case, the die 440 may represent the second die. The load die can be stacked on the second die in an inverted or non-inverted orientation.

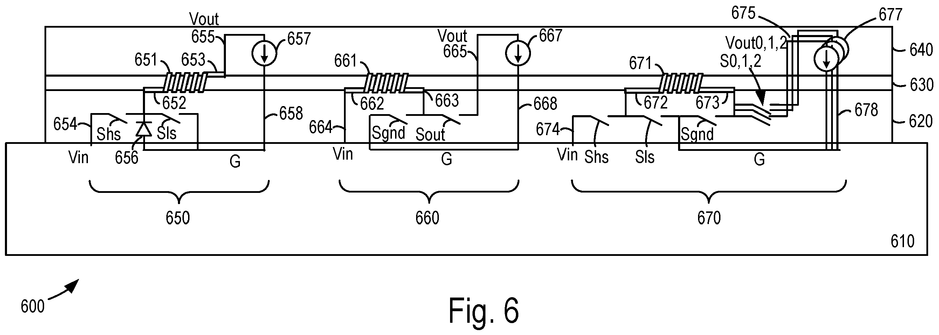

FIG. 6 depicts a cross-sectional view of a stack 600 comprising a package base layer 610, a VR die 620, a magnetic intermediate layer 630 and a load die 640, where a buck VR 650, a boost VR 660 and single-input, multiple-output (SIMO) VR 670 are formed with inductors 651, 661 and 671, respectively, located between the die, in accordance with various embodiments. A buck VR, or step-down converter, is a DC-to-DC converter which steps down voltage while stepping up current from its input

(supply) to its output (load). A boost converter, or step-up converter, is a DC-to-DC power converter that steps up voltage while stepping down current from its input (supply) to its output (load). A SIMO VR as depicted here acts as a buck or boost converter with multiple outputs. The different types of VRs are depicted together here in the same package for convenience. Generally, one or more VRs may be used.

The buck VR 650 includes an inductor 651 with an input end 652 and an output end 653. The input end 652 is coupled by a high side switch, Shs, to an input path 654, which receives Vin, and by a low side switch, SIs, to a ground path G. The switches can be transistors which are controlled by signals from a control circuit. In one approach, Shs is closed (made conductive) when SIs is open (made non-conductive), and Shs is opened when SIs is closed. Shs is closed according to a duty cycle such that a larger duty cycle results in a larger Vout. A diode 656 is coupled between ground and to a point between the switches. The output end 653 of the inductor is coupled to an output path 655 to provide Vout to a current sink 657 (a load in the load die), which in turn is coupled to ground by a ground path 658. The load can include one or more circuits in the load die which draw power from the output of the VR. The input end 652 of the inductor may be in the top metal layer of the VR die while the output end 653 is in the top metal later of the load die.

The boost VR 660 includes an inductor 661 with an input end 662 and an output end 663. The input end 662 is coupled to an input path 664, which receives Vin. The output end 663 of the inductor is coupled to a ground path via a ground switch Sgnd and to an output path 665 via an output switch Sout to provide Vout to a current sink 667, which in turn is coupled to ground by a ground path 668. The input and output ends of the inductor may both be in the top metal layer of the VR die.

The SIMO VR 670 includes an inductor 671 with an input end 672 and an output end 673. The input end 672 is coupled by a high side switch, Shs, to an input path 674, which receives Vin, and to a ground path via a low side switch SIs. The output end 673 of the inductor is coupled to ground via a ground switch Sgnd and to output paths 675 via respective output switches S0,1,2 to provide respective output voltages Vout0,1,2 to respective current sinks 677, which in turn are coupled to ground by respective ground paths 678. The input and output ends of the inductor may both be in the top metal layer of the VR die. This example depicts three outputs, but any number N>1 can be provided. The switches S0,1,2 are controlled according to respective control signals so that only one of the switches is closed at a time. Thus, only one output path is coupled to the inductor at a time. Each output can therefore be provided at a different level according to the duty cycle of its respective switch. An output capacitor, not shown, can also be provided for each output path in parallel with the respective current sink.

Generally, the buck converter can be implemented with an inductor, where the high-side and low-side switches (Shs and SIs) are on the VR die. The boost converter can be implemented similarly, and the output switch can be either on the VR die or the load die. The SIMO converter can be formed with most of the power switches on the VR die, while output switches have the option of being placed on the VR die or the load die. In these scenarios, as the inductor is not isolating input and output, both the VR die and the load die should have similar voltage ratings.

The die 620 is a first die and the die 640 is a second die.

FIG. 7 depicts a cross-sectional view of a stack 700 comprising a package base layer 710, a VR die 720, a magnetic intermediate layer 730 and a load die 740, where a transformer 750 of a fly back VR 790 is located between the die, in accordance with various embodiments.

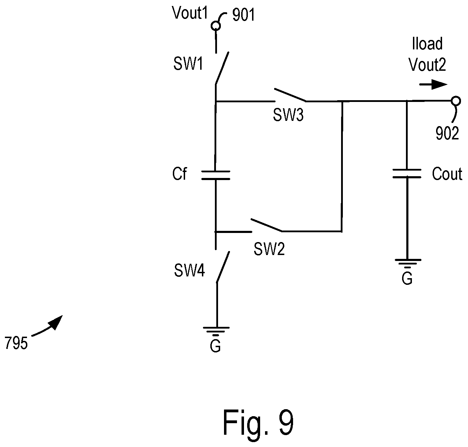

A transformer-based VR allows the input and output paths to be completely isolated from one another so that they can operate at different voltages, allowing for a high voltage ratio conversion. For example, FIGs. 7 and 8 provide examples of a fly back converter and FIG. 9 provides an example of a forward converter. In one approach, a 12 V input is provided to the VRs, and input GaN power switches are implemented in a 12 V-compliant GaN VR die, while other output switches on the secondary windings are implemented in a low-voltage load die. This can open a wide range of vertical integration in higher voltage scenarios, e.g., 48 V, because it allows separation across dies at different voltage levels, benefiting from very small path resistances only through vertical vias, and eliminating any high-current lateral routings.

Forward and fly back converters can be used to either increase or decrease the input voltage, or convert a single voltage to multiple output voltages.

A transformer typically includes two magnetically coupled coils. Alternating current in one coil, the primary coil or winding, creates a changing magnetic field which induces a current in the other coil, the secondary coil or winding. A transformer provides voltage transformation and isolation. An input voltage is provided to an input end of the primary winding and an output voltage is obtained from an output end of the secondary winding. The output voltage can be lower than the input voltage by a ratio 1/N when the primary-to-secondary turn ratio of the windings is N:1. The windings may wind around a magnetic material. The windings may extend over a common length of the magnetic intermediate layer or over different lengths as indicated here.

Generally, using the magnetic material, a transformer can be built between two dies. As the input and output are isolated, the input side can be built with a high-voltage process, while the output side is built with a low-voltage process. In a two-die configuration shown in FIGs. 7 and 9, the VR die receives a relatively high input voltage, e.g., 12-48 V and outputs a relatively low output voltage, e.g., 1 V. In a three-die configuration, as shown in FIG. 8, a first VR die receives a relatively high input voltage, e.g., 24-48 V, and outputs an intermediate voltage, e.g., 4 V, to a second VR die. The second VR die converts the intermediate voltage to a low voltage, e.g., 1 V, for use by the load die.

The transformer 750 includes a primary winding 751 and a secondary winding 752, which are wound around a magnetic material of the intermediate layer. An input voltage, Vin, is provided on an input path 760 to an input end 761 of the primary winding. An output end 762 of the primary winding is coupled to a ground path G by a switch 763. A magnetic field created in the magnetic material by the primary winding causes the secondary winding to provide an output voltage Vout across its input end 765 and output end 766. Vout is provided on an output path 764 in the load die, and through a diode 767 to a current sink 768 which represents a load. An output capacitor, Cout, is coupled in parallel with the load. A ground path 769 is coupled to the capacitor and the current sink.

In the fly back VR, when the switch 763 is closed, a first current flows through the primary winding to store energy in the transformer. The windings are two coupled inductors of the transformer that store energy when the switch 763 is closed. Additionally, a second current flows from Cout to the current sink. When the switch is open, current flows from the secondary winding, through the diode 767, to the current sink.

The die 720 is a first die and the die 740 is a second die.

FIG. 8 depicts a cross-sectional view of a stack 800 comprising a package base layer 810, a first VR die 820 for converting a high voltage Vin to an intermediate voltage Vout1, a magnetic intermediate layer 830, a second VR die 840 and a load die 850, where the transformer 750 is located between the first and second VR die, and an additional VR 795 in the second VR die 840 is used to down convert Vout1 to a low voltage, Vout2, in accordance with various embodiments. In this case, the output voltage on the path 764 in the second VR die is an intermediate voltage, Vout1. Vout1 passes through the diode 767 and is provided as an input voltage to the additional VR 795 which, in turn, provides an output Vout2 on a path 770 to a current sink 768 of the load die. An output capacitor, Cout, is coupled in parallel with the load. Cout is in the second VR die in this example. A ground path 769 is coupled to the VR 795, and a ground path 779 is coupled to the capacitor and the current sink.

Various types of VRs can be used for the VR 795. One example used a switched-capacitor VR such as in FIG. 9.

One advantage of this implementation is that the voltage reduction occurs in two stages, in first and second VRs arranged in cascade. In theory, more than two VR die and VRs could be used.

Generally, various designs of magnetic-based power converters can be realized with the solutions provided herein.

FIG. 9 depicts a circuit diagram of a 2:1 switched capacitor-based VR as an example implementation of the VR 795 of FIG. 8, in accordance with various embodiments. This example VR is configured as a single-stage charge pump with a single flying capacitor. A charge pump generally refers to a switching voltage converter that employs an intermediate capacitive storage element which is sometimes referred to as a flying capacitor or a charge transfer capacitor. One or more flying capacitors can be used. The charge pump is configured to provide Vout2<Vout1 in this example.

An input node 901 receives an input voltage Vout1. A set of switches SW1-SW4 are controlled by a control circuit to transfer charge from the input node to Cf, and from Cf to an output node 902. Vout2 is a resulting voltage at the output node and Iload is a current drawn by a load. The switches may be MOSFETs, BJTs, or relay switches, for example. SW1 and SW2 close (are conductive) at the same time, while SW3 and SW4 open (non-conductive). Similarly, SW1 and SW2 open at the same time, while SW3 and SW4 are closed. When closed, SW1 connects the top conductor of Cf to the input node 901 to receive a charge from Vout1 while SW2 connects the bottom conductor of Cfto the output node 902 to transfer its charge to the output node. When closed, SW4 connects the bottom conductor of Cf to a ground node and SW3 connects the top conductor of Cf to the output node 902 to transfer its charge to the output node.

The control circuit provides the switches with appropriate control signals to provide Vout2 at a desired level. The control circuit can include a sensor (see also FIG. 1) which monitors Vout2 at the output node via a feedback path. The CC can adjust the on/off times (duty cycle) of the switches to regulate Vout2 at a target level.

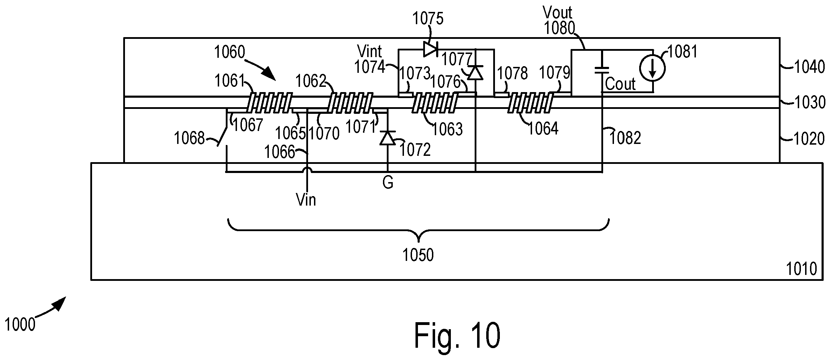

FIG. 10 depicts a cross-sectional view of a stack 1000 comprising a package base layer 1010, a VR die 1020, an intermediate layer 1030 and a load die 1040, where an example forward VR 1050 is formed with a transformer 1060 located between the die, in accordance with various embodiments. The VR includes a transformer 1060 comprising a primary winding 1061, a reset winding 1062 and a secondary winding 1063. The reset winding is to prevent the transformer's magnetic field from collapsing. The primary winding has an input end 1065 which receives Vin via an input path 1066. An output end 1067 of the primary winding is coupled to ground via a switch 1068. The reset winding has an input end 1070 which coupled to the input path 1066 and an output end 1071 coupled to a diode 1072. The secondary winding has an input end 1073 coupled to an output path 1074 to provide an intermediate voltage Vint to an input end 1078 of an inductor 1064 via a diode 1075. The diode 1075 is coupled to the output end 1076 of the secondary winding via a diode 1077. An output end 1079 of the inductor is coupled to a path 1080 to provide Vout to a current sink 1081. The current sink is coupled in parallel with Cout and in series with a ground path 1082.

In a forward VR, when the switch 1068 is closed, a first current flows through the primary winding to store energy in the transformer. Additionally, a second current flows from the secondary winding through the diode 1075 and inductor 1064 to the current sink. When the switch 1068 is closed, current flows through the capacitor Cout. The output voltage of the forward converter is controlled by the input voltage, the turns ratio between the primary and secondary windings and the duty cycle. An active clamp circuit can be used to eliminate the need for the reset winding 1062.

The die 1020 is a first die and the die 1040 is a second die.

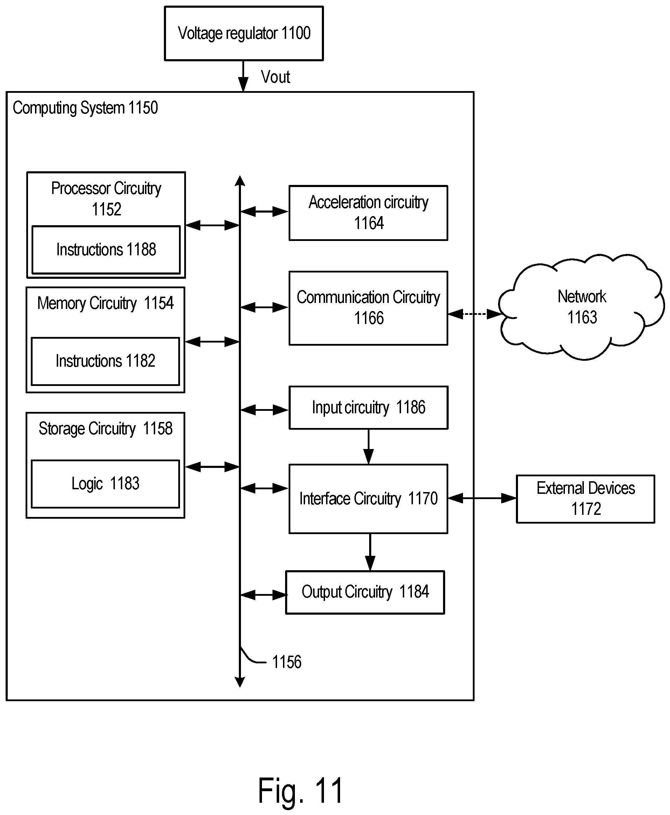

FIG. 11 illustrates an example of components that may be present in a computing system 1150 for implementing the techniques (e.g., operations, processes, methods, and methodologies) described herein. The voltage regulator 1100 may provide a voltage Vout to one or more of the components of the computing system 1150. The VR may be controlled by control signals provided by the processor circuitry 1152. The VR may include any of the VRs discussed herein including those in FIGs. 6-10.

The memory circuitry 1154 may store instructions and the processor circuitry 1152 may execute the instructions to perform the functions described herein.

The computing system 1150 may include any combinations of the hardware or logical components referenced herein. The components may be implemented as ICs, portions thereof, discrete electronic devices, or other modules, instruction sets, programmable logic or algorithms, hardware, hardware accelerators, software, firmware, or a combination thereof adapted in the computing system 1150, or as components otherwise incorporated within a chassis of a larger system. For one embodiment, at least one processor 1152 may be packaged together with computational logic 1182 and configured to practice aspects of various example embodiments described herein to form a System in Package (SiP) or a System on Chip (SoC).

The system 1150 includes processor circuitry in the form of one or more processors 1152. The processor circuitry 1152 includes circuitry such as, but not limited to one or more processor cores and one or more of cache memory, low drop-out voltage regulators (LDOs), interrupt controllers, serial interfaces such as SPI, I2C or universal programmable serial interface circuit, real time clock (RTC), timer-counters including interval and watchdog timers, general purpose I/O, memory card controllers such as secure digital/multi-media card (SD/MMC) or similar, interfaces, mobile industry processor interface (MIPI) interfaces and Joint Test Access Group (JTAG) test access ports. In some implementations, the processor circuitry 1152 may include one or more hardware accelerators (e.g., same or similar to acceleration circuitry 1164), which may be microprocessors, programmable processing devices (e.g., FPGA, ASIC, etc.), or the like. The one or more accelerators may include, for example, computer vision and/or deep learning accelerators. In some implementations, the processor circuitry 1152 may include on-chip memory circuitry, which may include any suitable volatile and/or non-volatile memory, such as DRAM, SRAM, EPROM, EEPROM, Flash memory, solid-state memory, and/or any other type of memory device technology, such as those discussed herein

The processor circuitry 1152 may include, for example, one or more processor cores (CPUs), application processors, GPUs, RISC processors, Acorn RISC Machine (ARM) processors, CISC processors, one or more DSPs, one or more FPGAs, one or more PLDs, one or more ASICs, one or more baseband processors, one or more radio-frequency integrated circuits (RFIC), one or more microprocessors or controllers, a multi-core processor, a multithreaded processor, an ultra-low-voltage processor, an embedded processor, or any other known processing elements, or any suitable combination thereof. The processors (or cores) 1152 may be coupled with or may include memory/storage and may be configured to execute instructions stored in the memory/storage to enable various applications or operating systems to run on the platform 1150. The processors (or cores) 1152 is configured to operate application software to provide a specific service to a user of the platform 1150. In some embodiments, the processor(s) 1152 may be a special-purpose processor(s)/controller(s) configured (or configurable) to operate according to the various embodiments herein.

As examples, the processor(s) 1152 may include an Intel^{®} Architecture Core^{™} based processor such as an i3, an i5, an i7, an i9 based processor; an Intel^{®} microcontroller-based processor such as a Quark^{™}, an Atom^{™}, or other MCU-based processor; Pentium^{®} processor(s), Xeon^{®} processor(s), or another such processor available from Intel^{®} Corporation, Santa Clara, California. However, any number other processors may be used, such as one or more of Advanced Micro Devices (AMD) Zen^{®} Architecture such as Ryzen^{®} or EPYC^{®} processor(s), Accelerated Processing Units (APUs), MxGPUs, Epyc^{®} processor(s), or the like; A5-A12 and/or S1-S4 processor(s) from Apple^{®} Inc., Snapdragon^{™} or Centriq^{™} processor(s) from Qualcomm^{®} Technologies, Inc., Texas Instruments, Inc.^{®} Open Multimedia Applications Platform (OMAP)^{™} processor(s); a MIPS-based design from MIPS Technologies, Inc. such as MIPS Warrior M-class, Warrior I-class, and Warrior P-class processors; an ARM-based design licensed from ARM Holdings, Ltd., such as the ARM Cortex-A, Cortex-R, and Cortex-M family of processors; the ThunderX2^{®} provided by Cavium^{™}, Inc.; or the like. In some implementations, the processor(s) 1152 may be a part of a system on a chip (SoC), System-in-Package (SiP), a multi-chip package (MCP), and/or the like, in which the processor(s) 1152 and other components are formed into a single integrated circuit, or a single package, such as the Edison^{™} or Galileo^{™} SoC boards from Intel^{®} Corporation. Other examples of the processor(s) 1152 are mentioned elsewhere in the present disclosure.

The system 1150 may include or be coupled to acceleration circuitry 1164, which may be embodied by one or more AI/ML accelerators, a neural compute stick, neuromorphic hardware, an FPGA, an arrangement of GPUs, one or more SoCs (including programmable SoCs), one or more CPUs, one or more digital signal processors, dedicated ASICs (including programmable ASICs), PLDs such as complex (CPLDs) or high complexity PLDs (HCPLDs), and/or other forms of specialized processors or circuitry designed to accomplish one or more specialized tasks. These tasks may include AI/ML processing (e.g., including training, inferencing, and classification operations), visual data processing, network data processing, object detection, rule analysis, or the like. In FPGA-based implementations, the acceleration circuitry 1164 may comprise logic blocks or logic fabric and other interconnected resources that may be programmed (configured) to perform various functions, such as the procedures, methods, functions, etc. of the various embodiments discussed herein. In such implementations, the acceleration circuitry 1164 may also include memory cells (e.g., EPROM, EEPROM, flash memory, static memory (e.g., SRAM, antifuses, etc.) used to store logic blocks, logic fabric, data, etc. in LUTs and the like.

In some implementations, the processor circuitry 1152 and/or acceleration circuitry 1164 may include hardware elements specifically tailored for machine learning and/or artificial intelligence (Al) functionality. In these implementations, the processor circuitry 1152 and/or acceleration circuitry 1164 may be, or may include, an AI engine chip that can run many different kinds of AI instruction sets once loaded with the appropriate weightings and training code. Additionally or alternatively, the processor circuitry 1152 and/or acceleration circuitry 1164 may be, or may include, AI accelerator(s), which may be one or more of the aforementioned hardware accelerators designed for hardware acceleration of AI applications. As examples, these processor(s) or accelerators may be a cluster of artificial intelligence (Al) GPUs, tensor processing units (TPUs) developed by Google^{®} Inc., Real AI Processors (RAPs^{™}) provided by AlphalCs^{®}, Nervana^{™} Neural Network Processors (NNPs) provided by Intel^{®} Corp., Intel^{®} Movidius^{™} Myriad^{™} X Vision Processing Unit (VPU), NVIDIA^{®} PX^{™} based GPUs, the NM500 chip provided by General Vision^{®}, Hardware 3 provided by Tesla^{®}, Inc., an Epiphany^{™} based processor provided by Adapteva^{®}, or the like. In some embodiments, the processor circuitry 1152 and/or acceleration circuitry 1164 and/or hardware accelerator circuitry may be implemented as AI accelerating co-processor(s), such as the Hexagon 685 DSP provided by Qualcomm^{®}, the PowerVR 2NX Neural Net Accelerator (NNA) provided by Imagination Technologies Limited^{®}, the Neural Engine core within the Apple^{®} A11 or A12 Bionic SoC, the Neural Processing Unit (NPU) within the HiSilicon Kirin 970 provided by Huawei^{®}, and/or the like. In some hardware-based implementations, individual subsystems of system 1150 may be operated by the respective AI accelerating co-processor(s), AI GPUs, TPUs, or hardware accelerators (e.g., FPGAs, ASICs, DSPs, SoCs, etc.), etc., that are configured with appropriate logic blocks, bit stream(s), etc. to perform their respective functions.

The system 1150 also includes system memory 1154. Any number of memory devices may be used to provide for a given amount of system memory. As examples, the memory 1154 may be, or include, volatile memory such as random access memory (RAM), static RAM (SRAM), dynamic RAM (DRAM), synchronous DRAM (SDRAM), RAMBUS^{®} Dynamic Random Access Memory (RDRAM^{®}), and/or any other desired type of volatile memory device. Additionally or alternatively, the memory 1154 may be, or include, non-volatile memory such as read-only memory (ROM), erasable programmable ROM (EPROM), electrically erasable programmable (EEPROM), flash memory, non-volatile RAM, ferroelectric RAM, phase-change memory (PCM), flash memory, and/or any other desired type of non-volatile memory device. Access to the memory 1154 is controlled by a memory controller. The individual memory devices may be of any number of different package types such as single die package (SDP), dual die package (DDP) or quad die package (Q17P). Any number of other memory implementations may be used, such as dual inline memory modules (DIMMs) of different varieties including but not limited to microDIMMs or MiniDIMMs.

Storage circuitry 1158 provides persistent storage of information such as data, applications, operating systems and so forth. In an example, the storage 1158 may be implemented via a solid-state disk drive (SSDD) and/or high-speed electrically erasable memory (commonly referred to as "flash memory"). Other devices that may be used for the storage 1158 include flash memory cards, such as SD cards, microSD cards, XD picture cards, and the like, and USB flash drives. In an example, the memory device may be or may include memory devices that use chalcogenide glass, multi-threshold level NAND flash memory, NOR flash memory, single or multi-level Phase Change Memory (PCM), a resistive memory, nanowire memory, ferroelectric transistor random access memory (FeTRAM), anti-ferroelectric memory, magnetoresistive random access memory (MRAM) memory that incorporates memristor technology, phase change RAM (PRAM), resistive memory including the metal oxide base, the oxygen vacancy base and the conductive bridge Random Access Memory (CB-RAM), or spin transfer torque (STT)-MRAM, a spintronic magnetic junction memory based device, a magnetic tunneling junction (MTJ) based device, a Domain Wall (DW) and Spin Orbit Transfer (SOT) based device, a thyristor based memory device, a hard disk drive (HDD), micro HDD, of a combination thereof, and/or any other memory. The memory circuitry 1154 and/or storage circuitry 1158 may also incorporate three-dimensional (3D) crosspoint (XPOINT) memories from Intel^{®} and Micron^{®}.

The memory circuitry 1154 and/or storage circuitry 1158 is/are configured to store computational logic 1183 in the form of software, firmware, microcode, or hardware-level instructions to implement the techniques described herein. The computational logic 1183 may be employed to store working copies and/or permanent copies of programming instructions, or data to create the programming instructions, for the operation of various components of system 1150 (e.g., drivers, libraries, application programming interfaces (APIs), etc.), an operating system of system 1150, one or more applications, and/or for carrying out the embodiments discussed herein. The computational logic 1183 may be stored or loaded into memory circuitry 1154 as instructions 1182, or data to create the instructions 1182, which are then accessed for execution by the processor circuitry 1152 to carry out the functions described herein. The processor circuitry 1152 and/or the acceleration circuitry 1164 accesses the memory circuitry 1154 and/or the storage circuitry 1158 over the interconnect (IX) 1156. The instructions 1182 direct the processor circuitry 1152 to perform a specific sequence or flow of actions, for example, as described with respect to flowchart(s) and block diagram(s) of operations and functionality depicted previously. The various elements may be implemented by assembler instructions supported by processor circuitry 1152 or high-level languages that may be compiled into instructions 1188, or data to create the instructions 1188, to be executed by the processor circuitry 1152. The permanent copy of the programming instructions may be placed into persistent storage devices of storage circuitry 1158 in the factory or in the field through, for example, a distribution medium (not shown), through a communication interface (e.g., from a distribution server (not shown)), over-the-air (OTA), or any combination thereof.

The IX 1156 couples the processor 1152 to communication circuitry 1166 for communications with other devices, such as a remote server (not shown) and the like. The communication circuitry 1166 is a hardware element, or collection of hardware elements, used to communicate over one or more networks 1163 and/or with other devices. In one example, communication circuitry 1166 is, or includes, transceiver circuitry configured to enable wireless communications using any number of frequencies and protocols such as, for example, the Institute of Electrical and Electronics Engineers (IEEE) 802.11 (and/or variants thereof), IEEE 802.23.4, Bluetooth^{®} and/or Bluetooth^{®} low energy (BLE), ZigBee^{®}, LoRaWAN^{™} (Long Range Wide Area Network), a cellular protocol such as 3GPP LTE and/or Fifth Generation (5G)/New Radio (NR), and/or the like. Additionally or alternatively, communication circuitry 1166 is, or includes, one or more network interface controllers (NICs) to enable wired communication using, for example, an Ethernet connection, Controller Area Network (CAN), Local Interconnect Network (LIN), DeviceNet, ControlNet, Data Highway+, or PROFINET, among many others.

The IX 1156 also couples the processor 1152 to interface circuitry 1170 that is used to connect system 1150 with one or more external devices 1172. The external devices 1172 may include, for example, sensors, actuators, positioning circuitry (e.g., global navigation satellite system (GNSS)/Global Positioning System (GPS) circuitry), client devices, servers, network appliances (e.g., switches, hubs, routers, etc.), integrated photonics devices (e.g., optical neural network (ONN) integrated circuit (IC) and/or the like), and/or other like devices.

In some optional examples, various input/output (I/O) devices may be present within or connected to, the system 1150, which are referred to as input circuitry 1186 and output circuitry 1184. The input circuitry 1186 and output circuitry 1184 include one or more user interfaces designed to enable user interaction with the platform 1150 and/or peripheral component interfaces designed to enable peripheral component interaction with the platform 1150. Input circuitry 1186 may include any physical or virtual means for accepting an input including, inter alia, one or more physical or virtual buttons (e.g., a reset button), a physical keyboard, keypad, mouse, touchpad, touchscreen, microphones, scanner, headset, and/or the like. The output circuitry 1184 may be included to show information or otherwise convey information, such as sensor readings, actuator position(s), or other like information. Data and/or graphics may be displayed on one or more user interface components of the output circuitry 1184. Output circuitry 1184 may include any number and/or combinations of audio or visual display, including, inter alia, one or more simple visual outputs/indicators (e.g., binary status indicators (e.g., light emitting diodes (LEDs)) and multi-character visual outputs, or more complex outputs such as display devices or touchscreens (e.g., Liquid Crystal Displays (LCD), LED displays, quantum dot displays, projectors, etc.), with the output of characters, graphics, multimedia objects, and the like being generated or produced from the operation of the platform 1150. The output circuitry 1184 may also include speakers and/or other audio emitting devices, printer(s), and/or the like. Additionally or alternatively, sensor(s) may be used as the input circuitry 1184 (e.g., an image capture device, motion capture device, or the like) and one or more actuators may be used as the output device circuitry 1184 (e.g., an actuator to provide haptic feedback or the like). Peripheral component interfaces may include, but are not limited to, a non-volatile memory port, a USB port, an audio jack, a power supply interface, etc. In some embodiments, a display or console hardware, in the context of the present system, may be used to provide output and receive input of an edge computing system; to manage components or services of an edge computing system; identify a state of an edge computing component or service; or to conduct any other number of management or administration functions or service use cases.

The components of the system 1150 may communicate over the IX 1156. The IX 1156 may include any number of technologies, including ISA, extended ISA, I2C, SPI, point-to-point interfaces, power management bus (PMBus), PCI, PCIe, PCIx, Intel^{®} UPI, Intel^{®} Accelerator Link, Intel^{®} CXL, CAPI, OpenCAPI, Intel^{®} QPI, UPI, Intel^{®} OPA IX, RapidIO^{™} system IXs, CCIX, Gen-Z Consortium IXs, a HyperTransport interconnect, NVLink provided by NVIDIA^{®}, a Time-Trigger Protocol (TTP) system, a FlexRay system, PROFIBUS, and/or any number of other IX technologies. The IX 1156 may be a proprietary bus, for example, used in a SoC based system.

The number, capability, and/or capacity of the elements of system 1150 may vary, depending on whether computing system 1150 is used as a stationary computing device (e.g., a server computer in a data center, a workstation, a desktop computer, etc.) or a mobile computing device (e.g., a smartphone, tablet computing device, laptop computer, game console, loT device, etc.). In various implementations, the computing device system 1150 may comprise one or more components of a data center, a desktop computer, a workstation, a laptop, a smartphone, a tablet, a digital camera, a smart appliance, a smart home hub, a network appliance, and/or any other device/system that processes data.

The techniques described herein can be performed partially or wholly by software or other instructions provided in a machine-readable storage medium (e.g., memory). The software is stored as processor-executable instructions (e.g., instructions to implement any other processes discussed herein). Instructions associated with the flowchart (and/or various embodiments) and executed to implement embodiments of the disclosed subject matter may be implemented as part of an operating system or a specific application, component, program, object, module, routine, or other sequence of instructions or organization of sequences of instructions.

The storage medium can be a tangible, non-transitory machine readable medium such as read only memory (ROM), random access memory (RAM), flash memory devices, floppy and other removable disks, magnetic storage media, optical storage media (e.g., Compact Disk Read-Only Memory (CD ROMS), Digital Versatile Disks (DVDs)), among others.

The storage medium may be included, e.g., in a communication device, a computing device, a network device, a personal digital assistant, a manufacturing tool, a mobile communication device, a cellular phone, a notebook computer, a tablet, a game console, a set top box, an embedded system, a TV (television), or a personal desktop computer.

Some non-limiting examples of various embodiments are presented below.

Example 1 includes an apparatus, comprising: a first die comprising a substrate and a plurality of metal layers above the substrate, including a first top metal layer; a second die comprising a substrate and a plurality of metal layers above the substrate, including a second top metal layer, wherein the second die is in a stack with the first die in an inverted position relative to the first die; and a voltage regulator comprising an input path in the first die, an output path in the second die and an inductor coupled to the input path and the output path, wherein the inductor comprises at least one of a portion of the first top metal layer or a portion of the second top metal layer.

Example 2 includes the apparatus of Example 1, wherein the inductor has a planar, spiral shape.

Example 3 includes the apparatus of Example 1 or 2, wherein the inductor comprises a plurality of vertical turns which include the portion of the first top metal layer and the portion of the second top metal layer.

Example 4 includes the apparatus of Example 3, further comprising a magnetic material between the first die and the second die, wherein the plurality of vertical turns are around the magnetic material.

Example 5 includes the apparatus of Example 3, further comprising a non-magnetic material between the first die and the second die, wherein the plurality of vertical turns are around the non-magnetic material.

Example 6 includes the apparatus of any one of Examples 1-5, wherein the voltage regulator is a buck converter and comprises, on the first die, a first switch to couple the input path to an input end of the inductor and a second switch to couple the input end of the inductor to ground.

Example 7 includes the apparatus of any one of Examples 1-6, wherein the voltage regulator is a boost converter and comprises, on the first die, a first switch to couple an output end of the inductor to ground and a second switch to couple the output end of the inductor to the output path.

Example 8 includes the apparatus of any one of Examples 1-7, wherein: the voltage regulator is a single-input, multiple-output converter; the output path is among a plurality of output paths in the second die; and the voltage regulator comprises, on the first die, a first switch to couple the input path to an input end of the inductor, and a second switch to couple the input end of the inductor to ground.

Example 9 includes the apparatus of any one of Examples 1-8, further comprising at least one of an integrated circuit, a System on Chip, a System in Package or a computing device in which the first die, second die and voltage regulator are provided, wherein the computing device comprises at least one of a processor circuitry, a memory circuitry, a storage circuitry, an acceleration circuitry, a communication circuitry, an input circuitry, an output circuitry, an interface circuitry or an external device.

Example 10 includes an apparatus, comprising: a first die; a second die stacked on the first die in an inverted position relative to the first die; a magnetic material between the first die and the second die; and a voltage regulator comprising an input path in the first die, an output path in the second die, a primary winding of a transformer around the magnetic material, and a secondary winding of the transformer around the magnetic material, wherein the primary winding is coupled to the input path, and the secondary winding is coupled to the output path.

Example 11 includes the apparatus of Example 10, wherein the second die is a load die comprising a circuit to be powered by the output path.

Example 12 includes the apparatus of Example 10, further comprising a load die stacked on the second die, wherein the second die comprises an additional voltage regulator to down convert a voltage at the output path to a down converted output voltage for use by the load die.

Example 13 includes the apparatus of any one of Examples 10-12, wherein: the first die comprises a substrate and a plurality of metal layers above the substrate, including a first top metal layer; the second die comprises a substrate and a plurality of metal layers above the substrate, including a second top metal layer; the primary winding comprises portions of the first top metal layer and portions of the second top metal layer; and the secondary winding comprises portions of the first top metal layer and portions of the second top metal layer.

Example 14 includes the apparatus of any one of Examples 10-13, wherein the voltage regulator is a fly back converter and comprises, on the first die, one or more switches coupled to the primary winding.

Example 15 includes the apparatus of any one of Examples 10-14, wherein: the voltage regulator is a forward converter and comprises an inductor coupled to the secondary winding; and the inductor comprises a winding around the magnetic material.

Example 16 includes the apparatus of anyone of Examples 10-15, wherein a substrate of the first die comprises gallium nitride and a substrate of the second die comprises silicon.

Example 17 includes a voltage regulator, comprising: a magnetic material between a first die and a second die; and a conductive coil wound around the magnetic material, wherein the conductive coil comprises portions of a metal layer of the first die and portions of a metal layer of the second die, and the second die is in an inverted orientation relative to the first die in a stack with the first die.

Example 18 includes the voltage regulator of Example 17, wherein the conductive coil comprises an inductor in an inductor-based voltage regulator.

Example 19 includes the voltage regulator of Example 17, wherein the conductive coil comprises a winding of a transformer in a transformer-based voltage regulator.

Example 20 includes the voltage regulator of any one of Examples 17-19, wherein: the second die is inverted relative to the first die; and the conductive coil comprises a portion of a top metal layer of the first die and a portion of a top metal layer of the second die.

Example 21 includes a method, comprising: receiving an input voltage at an input path of a voltage regulator and at an inductor coupled to the input path; and receiving an output voltage of the inductor at an output path of the voltage regulator, wherein: the input path is in a first die; the output path is in a second die; the first die comprises a substrate and a plurality of metal layers above the substrate, including a first top metal layer; the second die comprises a substrate and a plurality of metal layers above the substrate, including a second top metal layer; the second die is in a stack with the first die in an inverted position relative to the first die; and the inductor comprises at least one of a portion of the first top metal layer or a portion of the second top metal layer.

Example 22 includes a non-transitory machine-readable storage including machine-readable instructions that, when executed, cause a processor or other circuit or computing device to implement the method of Example 21.

Example 23 includes a computer program comprising instructions which, when the program is executed by a computer, cause the computer to carry out the method of Example 21.

Various operations may be described as multiple discrete actions or operations in turn, in a manner that is most helpful in understanding the claimed subject matter. However, the order of description should not be construed as to imply that these operations are necessarily order dependent. In particular, these operations may not be performed in the order of presentation. Operations described may be performed in a different order than the described embodiment. Various additional operations may be performed and/or described operations may be omitted in additional embodiments.

The terms "substantially," "close," "approximately," "near," and "about," generally refer to being within +/- 10% of a target value. Unless otherwise specified the use of the ordinal adjectives "first," "second," and "third," etc., to describe a common object, merely indicate that different instances of like objects are being referred to, and are not intended to imply that the objects so described must be in a given sequence, either temporally, spatially, in ranking or in any other manner.

For the purposes of the present disclosure, the phrases "A and/or B" and "A or B" mean (A), (B), or (A and B). For the purposes of the present disclosure, the phrase "A, B, and/or C" means (A), (B), (C), (A and B), (A and C), (B and C), or (A, B, and C).

The description may use the phrases "in an embodiment," or "in embodiments," which may each refer to one or more of the same or different embodiments. Furthermore, the terms "comprising," "including," "having," and the like, as used with respect to embodiments of the present disclosure, are synonymous.

As used herein, the term "circuitry" may refer to, be part of, or include an Application Specific Integrated Circuit (ASIC), an electronic circuit, a processor (shared, dedicated, or group), a combinational logic circuit, and/or other suitable hardware components that provide the described functionality. As used herein, "computer-implemented method" may refer to any method executed by one or more processors, a computer system having one or more processors, a mobile device such as a smartphone (which may include one or more processors), a tablet, a laptop computer, a set-top box, a gaming console, and so forth.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included. If the specification or claim refers to "a" or "an" element, that does not mean there is only one of the elements. If the specification or claims refer to "an additional" element, that does not preclude there being more than one of the additional elements.

Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

While the disclosure has been described in conjunction with specific embodiments thereof, many alternatives, modifications and variations of such embodiments will be apparent to those of ordinary skill in the art in light of the foregoing description. The embodiments of the disclosure are intended to embrace all such alternatives, modifications, and variations as to fall within the broad scope of the appended claims.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are highly dependent upon the platform within which the present disclosure is to be implemented (i.e., such specifics should be well within purview of one skilled in the art). Where specific details (e.g., circuits) are set forth in order to describe example embodiments of the disclosure, it should be apparent to one skilled in the art that the disclosure can be practiced without, or with variation of, these specific details. The description is thus to be regarded as illustrative instead of limiting.

An abstract is provided that will allow the reader to ascertain the nature and gist of the technical disclosure. The abstract is submitted with the understanding that it will not be used to limit the scope or meaning of the claims. The following claims are hereby incorporated into the detailed description, with each claim standing on its own as a separate embodiment.

## Claims

1. An apparatus, comprising:
a first die comprising a substrate and a plurality of metal layers above the substrate, including a first top metal layer;
a second die comprising a substrate and a plurality of metal layers above the substrate, including a second top metal layer, wherein the second die is in a stack with the first die in an inverted position relative to the first die; and
a voltage regulator comprising an input path in the first die, an output path in the second die and an inductor or transformer coupled to the input path and the output path, wherein the inductor or transformer comprises at least one of a portion of the first top metal layer or a portion of the second top metal layer.

2. The apparatus of claim 1, wherein the inductor has a planar, spiral shape.

3. The apparatus of claim 1 or 2, wherein the inductor or transformer comprises a plurality of vertical turns which include the portion of the first top metal layer and the portion of the second top metal layer.

4. The apparatus of claim 3, further comprising a magnetic material between the first die and the second die, wherein the plurality of vertical turns are around the magnetic material.

5. The apparatus of claim 4, wherein:
the plurality of vertical turns comprise a primary winding of the transformer around the magnetic material and a secondary winding of the transformer around the magnetic material, wherein the primary winding is coupled to the input path, and the secondary winding is coupled to the output path;
the primary winding comprises portions of the first top metal layer and portions of the second top metal layer; and
the secondary winding comprises portions of the first top metal layer and portions of the second top metal layer.

6. The apparatus of claim 3, further comprising a non-magnetic material between the first die and the second die, wherein the plurality of vertical turns are around the non-magnetic material.

7. The apparatus of any one of claims 1-6, wherein the voltage regulator is a buck converter and comprises, on the first die, a first switch to couple the input path to an input end of the inductor or transformer and a second switch to couple the input end of the inductor or transformer to ground.

8. The apparatus of any one of claims 1-6, wherein the voltage regulator is a boost converter and comprises, on the first die, a first switch to couple an output end of the inductor or transformer to ground and a second switch to couple the output end of the inductor or transformer to the output path.

9. The apparatus of any one of claims 1-8, wherein:
the voltage regulator is a single-input, multiple-output converter;
the output path is among a plurality of output paths in the second die; and
the voltage regulator comprises, on the first die, a first switch to couple the input path to an input end of the inductor or transformer , and a second switch to couple the input end of the inductor or transformer to ground.

10. The apparatus of any one of claims 1-9, further comprising at least one of an integrated circuit, a System on Chip, a System in Package or a computing device in which the first die, second die and voltage regulator are provided, wherein the computing device comprises at least one of a processor circuitry, a memory circuitry, a storage circuitry, an acceleration circuitry, a communication circuitry, an input circuitry, an output circuitry, an interface circuitry or an external device.

11. The apparatus of any one of claims 1-10, wherein the second die is a load die comprising a circuit to be powered by the output path.

12. The apparatus of any one of claims 1-11, further comprising a load die stacked on the second die, wherein the second die comprises an additional voltage regulator to down convert a voltage at the output path to a down converted output voltage for use by the load die.

13. The apparatus of any one of claims 1-12, wherein a substrate of the first die comprises gallium nitride and a substrate of the second die comprises silicon.

14. A method, comprising:
receiving an input voltage at an input path of a voltage regulator and at an inductor or transformer coupled to the input path; and
receiving an output voltage of the inductor or transformer at an output path of the voltage regulator, wherein:
the input path is in a first die;
the output path is in a second die;
the first die comprises a substrate and a plurality of metal layers above the substrate, including a first top metal layer;
the second die comprises a substrate and a plurality of metal layers above the substrate, including a second top metal layer;
the second die is in a stack with the first die in an inverted position relative to the first die; and
the inductor or transformer comprises at least one of a portion of the first top metal layer or a portion of the second top metal layer.

15. The method of claim 14, wherein the inductor has a planar, spiral shape or the inductor or transformer comprises a plurality of vertical turns which include the portion of the first top metal layer and the portion of the second top metal layer.
